(19) Europäisches Patentamt
European Patent Office
Office européen des brevets

(11) **EP 4 232 834 B1**

(12) **FASCICULE DE BREVET EUROPEEN**

(45) Date de publication et mention
de la délivrance du brevet:
**28.08.2024 Bulletin 2024/35**

(21) Numéro de dépôt: **21785941.2**

(22) Date de dépôt: **14.09.2021**

(51) Classification Internationale des Brevets (IPC):
*G01R 31/36* (2020.01)    *G01R 31/3835* (2019.01)
*G01R 31/389* (2019.01)    *G01R 31/396* (2019.01)
*G01R 31/68* (2020.01)

(52) Classification Coopérative des Brevets (CPC):
**G01R 31/3648; G01R 31/3835; G01R 31/389;
G01R 31/396; G01R 31/68;** Y02E 60/10

(86) Numéro de dépôt international:
**PCT/FR2021/051563**

(87) Numéro de publication internationale:
**WO 2022/084595 (28.04.2022 Gazette 2022/17)**

(54) **PROCEDE DE DETECTION D'UN DEFAUT D'UN GROUPE DE MODULES D'UNE BATTERIE**

VERFAHREN ZUR ERKENNUNG EINES FEHLERS EINER BATTERIEMODULGRUPPE

METHOD FOR DETECTING A FAULT OF A BATTERY MODULE GROUP

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **22.10.2020 FR 2010870**

(43) Date de publication de la demande:
**30.08.2023 Bulletin 2023/35**

(73) Titulaire: **Stellantis Auto SAS
78300 Poissy (FR)**

(72) Inventeurs:
• **GUERIN, Stephane
92250 LA GARENNE COLOMBES (FR)**
• **VIOLLIN, Pierre-mikael
78000 VERSAILLES (FR)**
• **MIZWICKI, Eric
95180 MENUCOURT (FR)**
• **NOIRET, Christian
92150 SURESNES (FR)**

(56) Documents cités:
**EP-A1- 3 079 220    US-A1- 2014 272 497**

**Description**

L'invention concerne un procédé de surveillance d'une batterie détectant un défaut d'un groupe de modules de cette batterie. Cette batterie comprend une série de modules connectés entre-deux par un système de barres omnibus (ou bus barre) généralement vissé à chaque borne électrique des modules.

On comprendra par batterie, dans tout le texte de ce document, un ensemble comprenant au moins deux module de batterie connectés en série, et contenant chacun au moins une cellule électrochimique. Cette batterie comprend éventuellement des moyens électriques ou électroniques pour la gestion d'énergie électrique de ses modules. Lorsqu'il y a plusieurs modules, ils sont regroupés dans un bac ou carter et forment alors un bloc batteries, ce bloc batteries étant souvent désigné par l'expression anglaise « pack batteries », ce carter contenant généralement une interface de montage, et des bornes de raccordement.

Par ailleurs, on comprendra par cellule électrochimique dans tout le texte de ce document, des cellules générant du courant par réaction chimique, par exemple de type lithium-ion (ou Li-ion), de type Ni-Mh, ou Ni-Cd ou encore plomb.

Ce vissage participe au maintien du système omnibus, mais également au bon contact électrique entre la borne et le système omnibus.

Malheureusement il arrive que ce vissage se desserre, par exemple à cause de vibrations transmises à la batterie. Ainsi la résistance de contact électrique entre la borne et le système omnibus augmente. Ceci est très néfaste car, avec le courant traversant cette résistance de contact, il peut apparaitre une élévation de température allant jusqu'à amorcer un départ d'incendie de la batterie.

EP 3 079 220 A1 divulgue un bloc de batteries et un procédé de détection de déconnexion.

On connait du document de brevet FR-A1-3051558 un dispositif d'analyse d'une résistance de contact. Malheureusement ce dispositif est couteux car il nécessite la mesure de la température au niveau de la résistance de contact. Mais surtout, ce dispositif manque de précision sur la détermination de cette résistance, car il utilise des modèles électrothermiques complexes qui prennent la température comme donnée d'entrée, si bien qu'il est nécessaire d'appliquer des marges de sécurité sur la valeur déterminée pour ne pas avoir de fausses détections de défauts de résistance de contact, aboutissant finalement à une détection tardive n'excluant pas un départ d'incendie.

Le but de l'invention est de remédier à ce manque en proposant un procédé améliorant la précision de détection de cette résistance, et dès l'apparition d'un défaut de serrage.

A cet effet, l'invention a pour objet un procédé de détection d'un défaut d'un groupe de modules d'une batterie comprenant :

- un premier ensemble de modules de batterie connectés en série et un premier moyen de mesure d'une première tension du premier ensemble de modules,
- un deuxième ensemble de modules de batterie connectés en série et un deuxième moyen de mesure d'une deuxième tension du deuxième ensemble de modules,

chaque module comprenant au moins une cellule et un moyen de mesure de la tension de la cellule, le premier ensemble étant connecté en série avec le deuxième ensemble, ce procédé comprenant les étapes successives suivantes :

- déterminer une valeur x selon la formule :

[math 1]

$$x = |k\Delta V_j - \Delta V_i|$$

où :

* Vi est la première tension du premier ensemble de modules,
* Vj est la deuxième tension du deuxième ensemble de modules,
* $\Delta V_i$ est la tension Vi soustraite de la somme de chaque tension des cellules du premier ensemble,
* $\Delta V_j$ est la tension Vj soustraite de la somme de chaque tension des cellules du deuxième ensemble,
* k est un coefficient de correction,

- comparer cette valeur x à un seuil, et
- confirmer que un des ensembles de modules a un défaut lorsque cette valeur x dépasse ce seuil.

Ainsi, ce procédé compare directement les premier et deuxième ensembles, en se basant sur le constat que :

- ces ensembles du même groupe sont soumis au même environnement, et sont donc soumis au même vieillissement des cellules, aux mêmes conditions thermiques,
- la probabilité d'avoir plusieurs défaillances au même instant et de même amplitude dans plusieurs des ensembles est nulle.

Par conséquent il ne peut pas y avoir d'écart entre les ensembles, sauf si il y a effectivement une anomalie dans l'un des ensembles.

Ce procédé est extrêmement simple, et permet naturellement de s'affranchir des variations naturelles de résistance internes liées au vieillissement et à la température par exemple, ces variations naturelles affectant les ensembles de la même manière. Ainsi ce procédé ne nécessite pas de mesure de température, ni de modèle électrothermique.

Cela permet en outre de baisser le seuil, seuil de détection, et détecter des plus faibles endommagements, avant qu'ils ne produisent des effets néfastes à fort coût de réparation. En outre, cela réduit également le risque de fausse détection due à une confusion entre les variations naturelles et une supposée anomalie locale.

Selon un mode de réalisation de l'invention, la batterie comprend n ensembles de modules, ces ensembles étant connectés en série, n étant supérieur ou égal à 2, et le procédé est exécuté pour chaque combinaison de deux tensions de deux ensembles distincts parmi les n ensembles, et si au moins la valeur x d'une combinaison dépasse le seuil, le procédé confirme que cette combinaison d'ensembles a un défaut.

Ainsi ce procédé s'adapte facilement à des groupes comprenant plus de deux ensembles. Le terme « combinaison » est à prendre au sens mathématique du terme.

Selon un mode de réalisation de l'invention, n est supérieur ou égal à 3, et ce procédé comprend :

- une étape de détermination de l'ensemble commun aux combinaisons détectées avec défaut,
- une étape de confirmation que cet ensemble commun est l'ensemble défectueux.

Ainsi, non seulement ce procédé détecte un défaut, mais lorsque n est supérieur ou égal à 3, il permet de localiser quel est l'ensemble présentant le défaut.

Selon un mode de réalisation de l'invention, lors de l'étape de détermination de la valeur x, le procédé rend cette valeur x sans dimension en la divisant par une tension, notamment par $\Delta Vi$ ou une moyenne entre $\Delta Vi$ et $\Delta Vj$.

Selon un mode de réalisation de l'invention, ce seuil est inférieur ou égal à 0,05 lorsque la valeur x est sans dimension, notamment lorsque x est divisé par $\Delta Vi$ ou une moyenne entre $\Delta Vi$ et $\Delta Vj$. Cette plage de valeurs de seuil est un exemple, et peut être adaptée en fonctions des objectifs de précision souhaités.

Bien entendu, la valeur x divisée par la tension doit se comprendre comme la nouvelle valeur x sans dimension à prendre en compte.

Selon un mode de réalisation de l'invention, l'étape de confirmation que un des ensembles de modules a un défaut comprend des sous-étapes prises individuellement ou en combinaison parmi :
une étape d'émission d'une alarme visuelle ou sonore,

- une étape de mise hors circuit de la batterie,
- une étape de mise hors circuit de chacun des modules,
- une étape de mise hors circuit de chacune des cellules,
- une étape de limitation du courant traversant les cellules.

L'invention a aussi pour objet un calculateur comprenant les moyens d'acquisition, de traitement par instructions logicielles stockées dans une mémoire ainsi que les moyens de commande requis à mise en oeuvre du procédé tel que précédemment décrit.

L'invention a aussi pour objet un système de batterie comprenant :

- un premier ensemble de modules de batterie connectés en série et un premier moyen de mesure d'une première tension du premier ensemble de modules,
- un deuxième ensemble de modules de batterie connectés en série et un deuxième moyen de mesure d'une deuxième tension du deuxième ensemble de modules,

chaque module comprenant au moins une cellule et un moyen de mesure de la tension de la cellule, le premier ensemble étant connecté en série avec le deuxième ensemble, ce système comprenant un calculateur tel que précédemment décrit.

Selon un mode de réalisation de l'invention, chaque ensemble de modules est identique.

On comprendra par ensembles identiques, dans tout le texte de ce document, des ensembles ayant les mêmes caractéristiques électriques à neuf aux dispersions de fabrication prés (capacité, tension nominale, résistance interne), et la même architecture : même nombre et type de modules, chaque module comprenant le même nombre de cellules et toutes les cellules du groupe étant elles aussi identiques et connectées entre-elles de la même façon.

L'invention a également pour objet un véhicule comprenant un système de batterie et une machine électrique motrice alimentée par ce système de batterie, ce système de batterie étant tel que précédemment décrit.

D'autres particularités et avantages apparaîtront à la lecture de la description ci-après d'un mode particulier de réalisation, non limitatif de l'invention, faite en référence aux figures dans lesquelles :

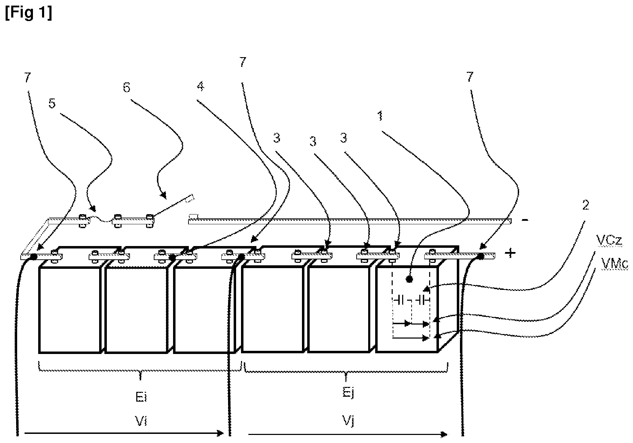

**[Fig 1]** : représente un système de batterie selon l'invention, simplifié, le calculateur n'étant pas représenté.

Il est à garder à l'esprit que la figure est donnée à titre d'exemples et n'est pas limitatives de l'invention. Elle constitue une représentation schématique de principe destinée à faciliter la compréhension de l'invention. Les références des éléments inchangés ou ayant la même fonction sont communes à chaque élément dupliqué.

L'invention porte donc sur un procédé de détection d'un défaut d'un groupe de modules 1 d'une batterie comprenant :

- un premier ensemble de modules Ei de batterie connectés en série et un premier moyen de mesure d'une première tension Vi du premier ensemble de modules Ei,
- un deuxième ensemble de modules Ej de batterie connectés en série et un deuxième moyen de mesure d'une deuxième tension Vj du deuxième ensemble de modules,

chaque module 1 comprenant au moins une cellule 2 et un moyen de mesure de la tension VCz, VMc de la cellule 2, le premier ensemble Ei étant connecté en série avec le deuxième ensemble Ej, ce procédé comprenant les étapes successives suivantes :

- déterminer une valeur x selon la formule

[math 2]

$$x = |k\Delta\text{Vj} - \Delta\text{Vi}|$$

où :

* Vi est la première tension du premier ensemble de modules Ei,
* Vj est la deuxième tension du deuxième ensemble de modules Ej,
* $\Delta$Vi est la première tension Vi soustraite de la somme de chaque tension VCz, VMc des cellules 2 du premier ensemble Ei,
* $\Delta$Vj est la deuxième tension Vj soustraite de la somme de chaque tension VCz, VMc des cellules 2 du deuxième ensemble Ej,
* k est un coefficient de correction,

- comparer cette valeur x à un seuil, et
- confirmer qu'un des ensembles de modules a un défaut lorsque cette valeur x dépasse ce seuil.

Le terme |$\Delta$V1-$\Delta$V2| est une valeur absolue.

Les termes Vi, Ei, Vj, Ej, VCz, VMc, comprennent respectivement des indices i, j, z, c.

Les indices i et j, i étant différents de j, évoluent entre un et n, n étant le nombre d'ensembles de modules Ei, Ej du groupe de modules. Par exemple pour un groupe de modules comprenant deux ensembles de modules E1, E2, on aura un couple d'ensemble E1, E2, ou un couple d'ensemble E2, E1 équivalent, la valeur x n'étant pas influencée par l'ordre des termes E1 et E2. Par exemple, pour un groupe de modules comprenant trois ensembles de modules E1, E2, E3, on aura un couple E1, E2 ou E2, E1, un couple E1, E3 ou E3, E1, un couple E2, E3 ou E3, E2, soit un nombre de combinaisons de trois.

L'indice z évolue en fonction du nombre de cellules 2 du groupe de modules, alors que l'indice c évolue en fonction du nombre de modules 1 du groupe de modules. En effet, sur la figure 1 sont représentés six modules 1 formant un unique groupe de modules, ces modules 1 étant répartis symétriquement dans deux ensembles de modules identiques E1, E2. Un seul module porte la référence 1, qui n'est pas répétée pour plus de clarté. Ce module référencé 1 comprend, de façon très schématique, deux cellules 2, par exemple les deux premières cellules du groupe de modules, et donc VC1 et VC2 seront les tensions mesurées aux bornes de chacune des deux premières cellules 2. Mais, dans le cadre de l'invention, on peut considérer une cellule équivalente à ces deux cellules 2, ce qui revient alors à mesurer la tension du premier module VM1 au bornes de sa cellule équivalente. Cependant, la valeur x aura une meilleur précision en utilisant VCz, qui est la tension aux bornes de chaque cellule 2, puisque dans ce cas le procédé sera à même de détecter des résistances de contact internes aux modules 1. On notera qu'une cellule 2 ayant une tension VCz peut être une cellule équivalente de plusieurs sous-cellules connectées en parallèle.

Comme expliqué précédemment, ce procédé compare directement les premier et deuxième ensembles E1, E2, en se basant sur le constat que :

- ces ensembles E1, E2 du même groupe sont soumis au même environnement, et sont donc soumis au même vieillissement des cellules 2, aux mêmes conditions thermiques et donc à même température,
- la probabilité d'avoir plusieurs défaillances au même instant et de même amplitude dans plusieurs des ensembles E1, E2 est nulle.

Or :

- $\Delta V1$ est en fait la somme d'une première variation de tension fonction du vieillissement des cellules 2 de l'ensemble E1 et de la température, et d'une deuxième variation de tension liée aux résistances de contact de l'ensemble E1, et de même :
- $\Delta V2$ est en fait la somme d'une troisième variation de tension fonction du vieillissement des cellules 2 de l'ensemble E2 et de la température, et d'une quatrième variation de tension liée aux résistances de contact de l'ensemble E2.

En prenant en compte les constats ci-dessus, si l'on compare $\Delta V1$ à $\Delta V2$ selon l'exemple de la figure 1, la première variation et la troisième variation sont identiques et s'annulent, l'une des deuxième et quatrième variations est nulle, et donc $|\Delta V1 - \Delta V2|$ est directement représentatif d'un défaut de résistance de contact sur l'un des deux ensembles de modules E1, E2.

Le coefficient k est par exemple égal à Vi/Vj, ou à une valeur fixe prédéterminée, et a pour but de corriger la valeur x pour un exemple de réalisation où les ensembles de modules Ei et Ej ne sont pas identiques, donc par exemple pas avec le même nombre de modules ou de cellules, et donc avec une différence de tension par construction entre les ensembles Ei, Ej. Ainsi, dans l'exemple de la figure 1, les deux ensembles de modules E1, E2 sont symétriques, et ont par construction une tension identique, et donc le coefficient k est égale à V1/V2, ou par exemple égal à une valeur fixe prédéterminée de un. Si en variante, par construction, le premier ensemble E1 comprend trois modules et le deuxième ensemble E2 un unique module, chacun de ces quatre modules étant par ailleurs identiques, le coefficient k sera égal à V1/V2, ou par exemple égal à une valeur fixe prédéterminée de trois, et ainsi de suite. Ce coefficient k est donc adapté à chaque couple de tension Vi, Vj pour lequel le procédé détermine la valeur x. Bien entendu, lorsque, comme illustré sur la figure 1 tous les ensembles de modules Ei, Ej sont identiques, on peut par exemple prédéterminer ce coefficient k à une unique valeur fixe de un pour toutes les déterminations de la valeur x.

Bien entendu, la batterie peut comprendre plusieurs groupes de modules, par exemple trois groupes de modules, ces trois groupes étant connectés en parallèle, en triangle, ou en étoile, de sorte par exemple à permettre la production d'un courant triphasé par le moyen d'un dispositif d'ondulation, intégré ou non à la batterie. De façon à détecter un défaut pour cette batterie, ce procédé sera exécuté pour chacun de ces trois groupes de modules.

La batterie comprend par exemple les n ensembles de modules Ei, Ej, d'un même groupe de modules, ces ensembles Ei, Ej étant connectés en série, n étant supérieur ou égal à 2, les étapes précédentes étant exécutées pour chaque combinaison de deux tensions Vi, Vj de deux ensembles distincts Ei, Ej parmi les n ensembles E1 à En, et si au moins la valeur x d'une combinaison dépasse le seuil, le procédé confirme que cette combinaison d'ensembles Ei, Ej a un défaut.

Par exemple, pour le groupe de modules comprenant trois ensembles de modules, on aura le couple E1, E2 ou E2, E1, le couple E1, E3 ou E3, E1, le couple E2, E3 ou E2, E3, soit un nombre de combinaisons de trois et donc trois déterminations de la valeur x. Ces combinaisons sont à prendre au sens mathématique du terme, et le nombre de combinaisons, et donc le nombre de déterminations de la valeur x est égal à :

[math 3]

$$\frac{n!}{2!\,(n-2)!}$$

Lorsque n est supérieur ou égal à 3, ce procédé comprend en outre :

- une étape de détermination de l'ensemble commun aux combinaisons détectées avec défaut,
- une étape de confirmation que cet ensemble commun est l'ensemble défectueux.

Ce procédé permet ainsi de localiser l'ensemble défectueux.

Lors de l'étape de détermination de la valeur x, le procédé rend cette valeur x sans dimension en la divisant par une tension, notamment par ΔVi ou une moyenne entre ΔVi et ΔVj. On notera que le cas où ΔVi ou ΔVj est égal à zéro est impossible, puisqu'il y aura toujours une résistance de contact sur des bornes de chaque module 1. De la même façon, ΔVi et ΔVj ont toujours une valeur positive.

Le seuil est alors également sans dimension, par exemple inférieur ou égal à 0,05.

Le fait de diviser |$k$ΔVj-ΔVi| par ΔV1 par exemple, rend la valeur x sans dimension, et peut être ainsi exprimée en pourcentages. Par exemple, la valeur x de 0,04 donnera 4%.

Ainsi la valeur x peut s'exprimer sous plusieurs formes, comme précédemment explicité, par exemple :

[math 4]

$$x = \frac{|k\Delta Vj - \Delta Vi|}{\Delta Vi}$$

ou par exemple :

[math 5]

$$x = \frac{\left|\frac{Vi}{Vj}\Delta Vj - \Delta Vi\right|}{\Delta Vi}$$

ou encore :

[math 6]

$$x = \frac{|k\Delta Vj - \Delta Vi|}{\Delta Vj + \Delta Vi}$$

L'étape de confirmation que un des ensembles de modules a un défaut comprend par exemple des sous-étapes prises individuellement ou en combinaison parmi :

- une étape d'émission d'une alarme visuelle ou sonore,
- une étape de mise hors circuit de la batterie,
- une étape de mise hors circuit de chacun des modules, notamment les modules de l'ensemble défectueux,
- une étape de mise hors circuit de chacune des cellules, notamment les cellules de l'ensemble défectueux,
- une étape de limitation du courant traversant les cellules.

Un calculateur comprendra les moyens d'acquisition, de traitement par instructions logicielles stockées dans une mémoire ainsi que les moyens de commande requis à mise en oeuvre du procédé selon l'invention. Ce calculateur est par exemple un système de gestion de batterie dit BMS pour l'acronyme anglais « battery management system ».

La figure 1 divulgue un système de batterie comprenant :

- le premier ensemble de modules Ei de batterie connectés en série et le premier moyen de mesure d'une première tension Vi du premier ensemble de modules Ei,
- le deuxième ensemble de modules Ej de batterie connectés en série et le deuxième moyen de mesure d'une deuxième tension Vj du deuxième ensemble de modules Ej,

chaque module 1 comprenant au moins la cellule 2 et le moyen de mesure de la tension VCz, VMc de la cellule 2, le premier ensemble Ei étant connecté en série avec le deuxième ensemble Ej. Ce système comprend en outre un calculateur (non représenté) selon l'invention.

Sur la figure 1, chaque ensemble de modules Ei, Ej est identique.

La figure 1 divulgue en outre un bus barre formant un circuit collectant les polarités + et - du groupe de modules dont tous les modules 1 sont connectés en série, ce bus barre comprenant plusieurs éléments 4 raccordant les modules 1 entre eux, par exemple par des moyens de vissage 3 vissant ces éléments de bus barre 4 sur les bornes + et - de chaque module 1. Chaque ensemble Ei, Ej de modules sont délimités par et entre deux piquages électriques 7, ces piquages électrique 7 permettant les mesures des tensions Vi, Vj. On aura donc dans cet exemple un piquage 7 central séparant les trois modules du premier ensemble Ei des trois modules du deuxième ensemble Ej. On notera que ce piquage 7 est pris sur un élément 4 du bus barre, entre deux moyens de vissage 3 de deux modules 1 distincts et voisins, de sorte à bien inclure la résistance de contact des moyens de serrage 3 dans la mesure de Vi et Vj. Ce bus barre comprend, toujours montés en série, un fusible 5 de sécurité, et un interrupteur 6 permettant par exemple la mise hors circuit de la batterie pour l'étape de mise hors circuit de la batterie.

Ce système de batterie comprend par exemple, et de façon non illustrée :

- un moyen d'émission ou de visualisation du défaut détecté, par exemple un haut-parleur ou un voyant positionnés dans un tableau de contrôle (ou tableau de bord pour un véhicule),
- un moyen de mise hors circuit de la cellule 2 et par cellule, par exemple en isolant cette cellule 2 et en la remplaçant par un shunt,
- un moyen de mise hors circuit d'un module 1 et par module 1, par exemple en isolant ce module 1 et en le remplaçant par un shunt,
- un moyen de limitation du courant par groupe de module, limitant le courant traversant le groupe de modules et donc chaque module 1.

Ce procédé permet avantageusement de détecter les défauts, c'est-à-dire une résistance de contact trop élevée sur chaque raccord entre les éléments 4 et une borne d'un module 1, ce défaut étant dû par exemple par un desserrage de l'un des moyens de vissage 3.

Ce système de batterie comprend par exemple un moyen de mesure du courant traversant le groupe de modules 1. Ce système de batterie est alors apte à déterminer la résistance interne que chaque ensemble Ei, Ej, proportionnellement aux nombre de modules dans chaque ensemble Ei, Ej, l'ensemble défectueux étant celui qui a la plus grande résistance interne. Cette localisation de l'ensemble défectueux sera avantageusement appliquée lorsque les ensembles Ei, Ej sont par construction identiques.

Cette invention s'applique tout particulièrement à un véhicule comprenant un système de batterie selon l'invention, et une machine électrique motrice alimentée par ce système de batterie. Mais cette invention est tout à fait adaptée à une application dans le domaine des stations fixes de stockage d'énergie électrique, ou des stations mobiles type chantier, notamment pour des systèmes de batterie des groupes électrogènes.

## Revendications

1. Procédé de détection d'un défaut d'un groupe de modules (1) d'une batterie comprenant :

   - un premier ensemble de modules (Ei) de batterie connectés en série et un premier moyen de mesure d'une première tension (Vi) du premier ensemble de modules (Ei),
   - un deuxième ensemble de modules (Ej) de batterie connectés en série et un deuxième moyen de mesure d'une deuxième tension (Vj) du deuxième ensemble de modules, chaque module (1) comprenant au moins une cellule (2) et un moyen de mesure de la tension (VCz, VMc) de la cellule (2), le premier ensemble (Ei) étant connecté en série avec le deuxième ensemble (Ej), **caractérisé en ce que** le procédé comprend les étapes successives suivantes :
   - déterminer une valeur x selon la formule

$$x = |k\Delta\mathrm{Vj} - \Delta\mathrm{Vi}|$$

   où :

   * Vi est la première tension du premier ensemble de modules (Ei),
   * Vj est la deuxième tension du deuxième ensemble de modules (Ej),
   * $\Delta$Vi est la première tension Vi soustraite de la somme de chaque tension (VCz, VMc) des cellules du premier ensemble (Ei),
   * $\Delta$Vj est la deuxième tension Vj soustraite de la somme de chaque tension (VCz, VMc) des cellules du deuxième ensemble (Ej),
   * k est un coefficient de correction,

- comparer cette valeur x à un seuil, et
- confirmer que un des ensembles de modules a un défaut lorsque cette valeur x dépasse ce seuil.

2. Procédé selon la revendication 1, la batterie comprenant n ensembles de modules (Ei, Ej), ces ensembles étant connectés en série, n étant supérieur ou égal à 2, **caractérisé en ce que** le procédé est exécuté pour chaque combinaison de deux tensions de deux ensembles distincts parmi les n ensembles, et si au moins la valeur x d'une combinaison dépasse le seuil, le procédé confirme que cette combinaison d'ensembles a un défaut.

3. Procédé selon la revendication 2, **caractérisé en ce que** n est supérieur ou égal à 3, ce procédé comprenant :

- une étape de détermination de l'ensemble commun aux combinaisons détectées avec défaut,
- une étape de confirmation que cet ensemble commun est l'ensemble défectueux.

4. Procédé selon l'une des revendications précédentes, **caractérisé en ce que** lors de l'étape de détermination de la valeur x, le procédé rend cette valeur x sans dimension en la divisant par une tension, notamment par $\Delta Vi$ ou une moyenne entre $\Delta Vi$ et $\Delta Vj$.

5. Procédé selon l'une des revendications précédentes, **caractérisé en ce que** l'étape de confirmation que un des ensembles de modules a un défaut comprend des sous-étapes prises individuellement ou en combinaison parmi :

- une étape d'émission d'une alarme visuelle ou sonore,
- une étape de mise hors circuit de la batterie,
- une étape de mise hors circuit de chacun des modules,
- une étape de mise hors circuit de chacune des cellules,
- une étape de limitation du courant traversant les cellules.

6. Calculateur, **caractérisé en ce qu'**il comprend les moyens d'acquisition, de traitement par instructions logicielles stockées dans une mémoire ainsi que les moyens de commande requis à mise en oeuvre du procédé selon l'une quelconque des revendications précédentes.

7. Système de batterie comprenant :

- un premier ensemble de modules (Ei) de batterie connectés en série et un premier moyen de mesure d'une première tension (Vi) du premier ensemble de modules (Ei),
- un deuxième ensemble de modules (Ej) de batterie connectés en série et un deuxième moyen de mesure d'une deuxième tension (Vj) du deuxième ensemble de modules (Ej), chaque module (1) comprenant au moins une cellule (2) et un moyen de mesure de la tension(VCz, VMc) de la cellule (2), le premier ensemble (Ei) étant connecté en série avec le deuxième ensemble (Ej), **caractérisée en ce qu'**il comprend un calculateur selon la revendication 6.

8. Système de batterie selon la revendication 7, **caractérisé en ce que** chaque ensemble de modules (Ei, Ej) est identique.

9. Véhicule comprenant un système de batterie et une machine électrique motrice alimentée par ce système de batterie, **caractérisé en ce que** le système de batterie est conforme à la revendication 7 ou 8.


**Patentansprüche**

1. Verfahren zur Erkennung eines Fehlers in einer Gruppe von Modulen (1) einer Batterie, umfassend:

- einen ersten Satz in Reihe geschalteter Batteriemodule (Ei) und ein erstes Mittel zum Messen einer ersten Spannung (Vi) des ersten Satzes von Modulen ( Ei),
- einen zweiten Satz von Batteriemodulen (Ej), die in Reihe geschaltet sind, und ein zweites Mittel zum Messen einer zweiten Spannung (Vj) des zweiten Satzes von Modulen, wobei

jedes Modul (1) mindestens eine Zelle (2) und Mittel umfasst zum Messen der Spannung (VCz, VMc) der Zelle (2), wobei der erste Satz (Ei) mit dem zweiten Satz (Ej) in Reihe geschaltet ist, **dadurch gekennzeichnet, dass** das Verfahren die folgenden aufeinanderfolgenden Schritte umfasst:

- Bestimmen eines Wertes x nach der Formel

$$x = |k\Delta V j - \Delta V i|$$

wobei:

    * V i die erste Spannung des ersten Modulsatzes (Ei) ist,
    * V j die zweite Spannung des zweiten Modulsatzes (Ej) ist,
    * $\Delta$Vidie erste Spannung Vi ist, die von der Summe jeder Spannung subtrahiert wird ( VCz, VMc) der Zellen des ersten Satzes (Ei),
    * $\Delta$Vjist die zweite Spannung Vj, die von der Summe jeder Spannung (VCz, VMc) der Zellen des zweiten Satzes (Ej) subtrahiert wird,
    * k ist ein Korrekturkoeffizient , - diesen Wert x mit einem Schwellenwert vergleichen und

- bestätigen, dass einer der Modulsätze einen Fehler aufweist, wenn dieser Wert x diesen Schwellenwert überschreitet.

2. Verfahren nach Anspruch 1, wobei die Batterie n Sätze von Modulen (Ei, Ej) umfasst, wobei diese Sätze in Reihe geschaltet sind, wobei n größer oder gleich 2 ist, **dadurch gekennzeichnet, dass** das Verfahren für jede Kombination von zwei Spannungen von zwei ausgeführt wird unterschiedliche Mengen unter den n Mengen, und wenn mindestens der Wert x einer Kombination den Schwellenwert überschreitet, bestätigt die Methode, dass diese Kombination von Mengen einen Fehler aufweist.

3. Verfahren nach Anspruch 2, **dadurch gekennzeichnet, dass** n größer oder gleich 3 ist, wobei dieses Verfahren Folgendes umfasst:

    - einen Schritt zur Bestimmung der Menge, die den als fehlerhaft erkannten Kombinationen gemeinsam ist,
    - einen Schritt zur Bestätigung, dass diese gemeinsame Menge die fehlerhafte Baugruppe ist.

4. Verfahren nach einem der vorhergehenden Ansprüche, **dadurch gekennzeichnet, dass** das Verfahren im Schritt der Bestimmung des Wertes x diesen Wert x dimensionslos macht, indem es ihn durch eine Spannung dividiert, insbesondere durch $\Delta$Vioder einen Mittelwert zwischen $\Delta$Vi et $\Delta$Vj.

5. Verfahren nach einem der vorhergehenden Ansprüche, **dadurch gekennzeichnet, dass** der Schritt des Bestätigens, dass einer der Modulsätze einen Fehler aufweist, Unterschritte umfasst, die einzeln oder in Kombination durchgeführt werden:

    - einen Schritt des Aussendens eines visuellen Alarms oder eines Tons,
    - a Schritt des Abschaltens der Batterie, - Schritt des Abschaltens jedes Moduls, - Schritt des Abschaltens jeder Zelle, - Schritt des Begrenzens des durch die Zellen fließenden Stroms.

6. Computer, **dadurch gekennzeichnet, dass** er die Mittel zur Erfassung, Verarbeitung durch in einem Speicher gespeicherte Softwareanweisungen sowie die zur Umsetzung des Verfahrens nach einem der vorhergehenden Ansprüche erforderlichen Steuermittel umfasst.

7. Batteriesystem, bestehend aus:

    - einem ersten Satz in Reihe geschalteter Batteriemodule (Ei) und einem ersten Mittel zum Messen einer ersten Spannung (Vi) des ersten Satzes von Modulen (Ei),
    - einem zweiten Satz von Modulen ( Ej) aus Batterien in Reihe geschaltet und ein zweites Mittel zum Messen einer zweiten Spannung (Vj) des zweiten Satzes von Modulen (Ej), wobei

jedes Modul (1) mindestens eine Zelle (2) und ein Mittel zum Messen der Spannung (VCz, VMc) umfasst. der Zelle (2), wobei der erste Satz (Ei) mit dem zweiten Satz (Ej) in Reihe geschaltet ist, **dadurch gekennzeichnet, dass** er einen Rechner nach Anspruch 6 umfasst.

8. Batteriesystem nach Anspruch 7, **dadurch gekennzeichnet, dass** jeder Modulsatz (Ei, Ej) identisch ist.

9. Fahrzeug umfassend ein Batteriesystem und eine von diesem Batteriesystem angetriebene elektrische Antriebsmaschine, **dadurch gekennzeichnet, dass** das Batteriesystem Anspruch 7 oder 8 entspricht.

**Claims**

1. Method for detecting a fault in a group of modules (1) of a battery comprising:

   - a first set of battery modules (Ei) connected in series and a first means of measuring a first voltage (Vi) of the first set of modules (Ei),
   - a second set of battery modules (Ej) connected in series and a second means for measuring a second voltage (Vj) of the second set of modules,

   each module (1) comprising at least one cell (2) and means for measuring the voltage (VCz, VMc) of the cell (2), the first set (Ei) being connected in series with the second set (Ej), **characterized in that** the method includes the following successive steps:

   - determine a value x according to the formula

   $$x = |k\Delta\text{Vj} - \Delta\text{Vi}|$$

   where:

   * $V_i$ is the first voltage of the first set of modules (Ei),
   * Vj is the second voltage of the second set of modules (Ej),
   * ΔVi is the first voltage Vi subtracted from the sum of each voltage (VCz, VMc) of the cells of the first set (Ei),
   * ΔVj is the second voltage Vj subtracted from the sum of each voltage (VCz, VMc) of the cells of the second set (Ej),
   * k is a correction coefficient, - compare this value x at a threshold, and

   - confirm that one of the sets of modules has a fault when this value x exceeds this threshold.

2. Method according to claim 1, the battery comprising n sets of modules (Ei, Ej), these sets being connected in series, n being greater than or equal to 2, **characterized in that** the method is executed for each combination of two voltages of two distinct sets among the n sets, and if at least the value x of a combination exceeds the threshold, the method confirms that this combination of sets has a defect.

3. Method according to claim 2, **characterized in that** n is greater than or equal to 3, this method comprising:

   - a step of determining the set common to the combinations detected with fault,
   - a step of confirming that this common set is the defective assembly.

4. Method according to one of the preceding claims, **characterized in that** during the step of determining the value x, the method makes this value x dimensionless by dividing it by a voltage, in particular by ΔVi or an average between ΔVi et ΔVj.

5. Method according to one of the preceding claims, **characterized in that** the step of confirming that one of the sets of modules has a fault comprises sub-steps taken individually or in combination among:

   - a step of emitting a visual alarm or sound,
   - a step of switching off the battery, - a step of switching off each of the modules, - a step of switching off each of the cells, - a step of limiting the current passing through the cells.

6. Computer, **characterized in that** it comprises the means of acquisition, processing by software instructions stored in a memory as well as the control means required to implement the method according to any one of the preceding claims.

7. Battery system comprising:

   - a first set of battery modules (Ei) connected in series and a first means of measuring a first voltage (Vi) of the first set of modules (Ei),
   - a second set of modules ( Ej) of batteries connected in series and a second means for measuring a second voltage (Vj) of the second set of modules (Ej),

   each module (1) comprising at least one cell (2) and a means for measuring the voltage (VCz, VMc) of the cell (2), the first set (Ei) being connected in series with the second set (Ej), **characterized in that** it comprises a calculator according to claim 6.

8. Battery system according to claim 7, **characterized in that** each set of modules (Ei, Ej) is identical.

9. Vehicle comprising a battery system and an electric driving machine powered by this battery system, **characterized in that** the battery system conforms to claim 7 or 8.

[Fig 1]

**RÉFÉRENCES CITÉES DANS LA DESCRIPTION**

**Documents brevets cités dans la description**

- EP 3079220 A1
- FR 3051558 A1